# EUROPÄISCHE PATENTSCHRIFT

(11) **EP 3 268 790 B1**
(45) Veröffentlichungstag und Bekanntmachung des Hinweises auf die Patenterteilung: **30.04.2025**
(21) Anmeldenummer: 16706356.9
(22) Anmeldetag: 25.02.2016
(51) Int. Cl.: G02B 7/18, G03F 7/00, G02B 17/06, G02B 19/00

(54) **VERFAHREN ZUM HERSTELLEN EINES SPIEGELS FÜR EINE LITHOGRAPHIEANLAGE**
METHOD FOR PRODUCING A MIRROR FOR A LITHOGRAPHY APPARATUS
PROCÉDÉ DE FABRICATION D'UN MIROIR POUR UNE INSTALLATION DE LITHOGRAPHIE

(30) Priorität: 12.03.2015 DE 102015204454; 04.12.2015 DE 102015224281
(43) Veröffentlichungstag der Anmeldung: 17.01.2018
(73) Patentinhaber: Carl Zeiss SMT GmbH, 73447 Oberkochen (DE)
(72) Erfinder: LAUFER, Timo, 70180 Stuttgart (DE); AKBARINIA, Alireza, 89520 Heidenheim (DE)
(74) Vertreter: Horn Kleimann Waitzhofer Schmid-Dreyer Patent- und Rechtsanwälte PartG mbB
(86) Internationale Anmeldenummer: PCT/EP2016/054033
(87) Internationale Veröffentlichungsnummer: WO 2016/142185

(56) Entgegenhaltungen:
- EP-A1- 0 532 236
- WO-A2-2014/139763
- DE-A1- 102013 201 805

## Beschreibung

Die Erfindung betrifft ein Verfahren zum Herstellen eines Spiegels für eine Lithographieanlage. Dabei handelt es sich bei der Lithographieanlage insbesondere um eine EUV- oder DUV-Lithographieanlage.

Es wird auf den Inhalt der Prioritätsanmeldungen DE 10 2015 204 454.8 und DE 10 2015 224 281.1 hingewiesen.

Lithographieanlagen werden beispielsweise bei der Herstellung von integrierten Schaltungen bzw. ICs verwendet, um ein Maskenmuster in einer Maske (auch als Retikel bezeichnet) auf ein Substrat, wie beispielsweise einem Siliziumwafer, abzubilden. Insbesondere umfassen derartige Lithographieanlagen eine Beleuchtungseinrichtung und ein Projektionsobjektiv. Das Bild der mittels der Beleuchtungseinrichtung beleuchteten Maske wird mittels des Projektionsobjektivs auf das mit einer lichtempfindlichen Schicht (photoresist) beschichtete und in der Bildebene des Projektionsobjektivs angeordnete Substrat projiziert, um das Maskenmuster auf die lichtempfindliche Schicht des Substrats zu übertragen.

In für den EUV-Bereich ausgelegten Projektionsobjektiven, das heißt bei Wellenlängen von beispielsweise etwa 13 nm, werden mangels Verfügbarkeit geeigneter lichtdurchlässiger Materialien Spiegel als optische Komponenten für den Abbildungsprozess verwendet. Ein dabei auftretendes Problem ist, dass die Spiegel infolge Absorption der von der EUV-Lichtquelle emittierten Strahlung (Belichtung der Maske) aber auch aufgrund anderer Wärmequellen eine Erwärmung und eine damit einhergehende thermische Verformung erfahren. Diese thermischen Verformungen - sowohl lokal im Bereich der optischen Fläche, welche belichtet wird, wie auch im gesamten Spiegel - ergeben sich dabei als Funktion der Wärmestromverteilung sowie des materialabhängigen thermischen Ausdehnungskoeffizienten. Die optischen Verformungen können wiederum zu Beeinträchtigungen bei der Abbildung mittels des Projektionsobjektivs führen. Das Problem der thermischen Verformung ist im Übrigen nicht auf EUV-Lithographieanlagen beschränkt. Vielmehr besteht dieses Problem auch bei herkömmlichen Lithographieanlagen, die beispielsweise von ArF Excimer Lasern Gebrauch machen und insbesondere mit einer Wellenlänge von 192 nm und einer Kombination von entsprechenden Linsen und Spiegeln als optische Elemente operieren.

Die WO 2014/139763 A2 zeigt eine Reflektorvorrichtung mit einem Reflektor und einer Anordnung von thermoelektrischen Wärmepumpen, die wärmeleitend mit dem Reflektor verbunden sind. Weiterhin umfasst die Reflektorvorrichtung eine Steuereinrichtung, die eingerichtet ist, die thermoelektrischen Wärmepumpen anzusteuern und eine Temperatur des Reflektors aus einer gemessenen Spannung an zumindest einer der thermoelektrischen Wärmepumpen zu bestimmen. Ferner zeigt die DE 10 2013 201 805 A1 eine Lithographieanlage, welche ein optisches Element, eine Kühlvorrichtung zur Kühlung des optischen Elements mit mindestens einem Kühlelement und einen Aktuator zum Verschieben des Kühlelements und des optischen Elements relativ zueinander umfasst.

Weiterhin zeigt die EP 0 532 236 A1 ein System zur Stabilisierung der Formen von optischen Elementen, eine Belichtungsvorrichtung unter Verwendung dieses Systems und ein Verfahren zur Herstellung von Halbleitervorrichtungen.

Vor diesem Hintergrund besteht eine Aufgabe der vorliegenden Erfindung darin, ein Verfahren zum Herstellen eines Spiegels bereitzustellen, bei dem die Deformation des Spiegels im Belichtungsprozess der Lithographieanlage möglichst gering ausfällt.

Diese Aufgabe wird durch die Merkmale des unabhängigen Anspruchs gelöst. Es wird ein Verfahren zum Herstellen eines Spiegels für eine Lithographieanlage, mit den folgenden Schritten vorgeschlagen. In einem ersten Schritt a) wird eine zu erwartende Wärmestromverteilung auf dem Spiegel ermittelt. In einem zweiten Schritt b) werden mehrere Heizzonen auf dem Spiegel in Abhängigkeit von der ermittelten Wärmestromverteilung gebildet. In einem dritten Schritt c) wird eine jeweilige Heizzone mit einer jeweiligen Heizeinrichtung zum Beheizen der jeweiligen Heizzone in Abhängigkeit von einer erfassten Temperatur der jeweiligen Heizzone oder der zu erwartenden Wärmestromverteilung auf dem Spiegel versehen.

Vorteilhafterweise kann bei einem so hergestellten Spiegel die Temperatur in allen Heizzonen des Spiegels konstant bzw. nahezu konstant gehalten werden. Dadurch können Deformationen des Spiegels aufgrund einer Erwärmung, insbesondere einer unterschiedlich starken Erwärmung in unterschiedlichen Heizzonen des Spiegels, vermieden bzw. nahezu vermieden werden. Insbesondere können verschiedene Heizzonen (ggf. erst kurz vor "starting exposure") unterschiedlich stark vorgeheizt werden, bevor die Belichtung des Wafers der Lithographieanlage einsetzt und damit die Erwärmung des Spiegels durch die Strahlung der Lithographieanlage für die Belichtung einsetzt. Dabei können die verschiedenen Heizzonen sowohl vor der erstmaligen Einschaltung der Belichtung des Wafers als auch vor oder bei einer Umschaltung zwischen zwei verschiedenen Beleuchtungssettings und/oder Retikelwechseln vorgeheizt werden, bzw. das Heizen der Heizzonen kann angepasst werden.

In dem ersten Schritt a) wird bevorzugt durch Berechnungen und/oder Simulationen anhand von Modellen ermittelt, welche Wärmestromverteilung auf dem Spiegel zu erwarten ist. Die zu erwartenden Wärmestromverteilung auf dem Spiegel ist also diejenige Verteilung, die anhand von Modellen und Berechnungen und/oder Simulationen zu diesen Modellen ermittelt wird. Dadurch können in dem zweiten Schritt b) die Heizzonen auf dem Spiegel so gewählt werden, dass Gebiete mit besonders hoher Temperatur, sogenannte Wärmestrompole, geeignet auf die Heizzonen verteilt werden. Dadurch lässt sich dann, durch eine entsprechende Beheizung der einzelnen Heizzonen, eine konstante Temperaturverteilung in dem Spiegelkörper des Spiegels realisieren. Mit den in dem dritten Schritt c) vorgesehenen Heizeinrichtungen zum Beheizen der jeweiligen Heizzonen, kann jede Heizzone in Abhängigkeit von der jeweils erfassten Temperatur oder in Abhängigkeit von der zu erwartenden Wärmestromverteilung beheizt werden. Somit lässt sich eine konstante Temperatur in jeder Heizzone erreichen. In dem Fall, dass eine Wärmestromverteilung pro Heizzone ermittelt wurde, kann die Heizeinrichtung entsprechend der Wärmestromverteilung mit einem entsprechenden Heizmuster auf die Wärmestromverteilung eingehen.

Der Spiegelkörper des Spiegels kann zusätzlich mittels einer Einrichtung zur Reduzierung der Spiegeltemperatur gekühlt werden, um das Temperaturniveau des Spiegelkörpers insgesamt zu senken bzw. anzupassen.

Anders gesagt besteht eine der vorliegenden Erfindung zugrunde liegende Erkenntnis darin, dass typische Wärmestromverteilungen auf dem Spiegel im Belichtungsbetrieb der Lithographieanlage einem Muster entsprechen, welches sich einfach in einige wenige prägnant heiße und (im Vergleich dazu) prägnant kalte Zonen unterteilen lässt. Die Temperatur einer jeweiligen (Heiz-)Zone lässt sich dann mit wenig Aufwand (nur ein Temperatursensor pro Heizzone kann genügen) erfassen und durch Heizen und/oder Kühlen dahingehend steuern, dass die Verformung des Spiegels und mithin ein Abbildungsfehler des Spiegels minimiert wird. Es können auch IR-Kameras zur Temperaturmessung verwendet werden. Alternativ wird die Temperatur nicht gemessen, sondern die zu erwartende Wärmestromverteilung wird verwendet, um die einzelnen Heizzonen entsprechend zu temperieren.

Die zu erwartende Wärmestromverteilung wird in Abhängigkeit der auf dem Wafer abzubildenden Struktur ermittelt. Je nachdem, um welches Retikel es sich handelt, und welche Strukturen mittels der Lithographieanlage auf dem Wafer abgebildet werden sollen, ergibt sich ein unterschiedlicher Wärmestrom bzw. eine unterschiedliche Wärmestromverteilung auf dem Spiegel.

Die zu erwartende Wärmestromverteilung umfasst mehrere Wärmestrompole. Durch die Verwendung von mehreren Heizzonen kann individuell auf die Wärmestromverteilung mit einem oder mehreren Wärmestrompolen eingegangen werden. Bei den Wärmestrompolen handelt es sich um einige wenige Zonen mit hohem Wärmeeintrag, die sich von den umliegenden Zonen mit geringerem Wärmeeintrag deutlich abheben.

Einer Heizzone wird genau ein Wärmestrompol zugeordnet. Vorteilhafterweise kann jeder Wärmepol in einer separaten Heizzone liegen. Damit lässt sich die Temperatur einer jeden Heizzone konstant halten, da man mit der Beheizung einer Heizzone individuell auf den Wärmepol eingehen kann. Weiter kann auch jeder Heizzone genau ein Wärmestrompol zugeordnet werden.

Gemäß einer weiteren Ausführungsform des Verfahrens weist die zu erwartende Wärmestromverteilung einen X-Dipol, einen Y-Dipol und/oder ein DRAM-Profil auf. Die zu erwartende Wärmestromverteilung kann prinzipiell ein beliebiges Wärmestrommuster sein.

Gemäß einer weiteren Ausführungsform des Verfahrens werden zwischen 3-10, 3-20, 3-30 oder 3-100 Heizzonen gebildet. Es können auch 3-200 Heizzonen gebildet werden. Prinzipiell ist es gewünscht mit möglichst wenigen Heizzonen eine möglichst konstante Temperaturverteilung des Spiegelvolumens zu gewährleisten. Je weniger Heizzonen gebildet werden, desto unkomplizierter ist die thermische Konditionierung des Spiegels und damit die Herstellung der Konditioniereinheit. In den meisten Fällen kann mit 3-10 Heizzonen ein gutes Ergebnis erzielt werden. Beispielsweise kann eine jeweilige Heizzone eine Fläche größer 5 cm², bevorzugt größer 10 cm² und noch weiter bevorzugt größer 100 cm² aufweisen.

Gemäß einer weiteren Ausführungsform des Verfahrens weist der Spiegel einen optisch aktiven Bereich und einen optisch inaktiven Bereich auf, und bevorzugt werden im optisch aktiven Bereich und/oder im optisch inaktiven Bereich ein oder mehrere Heizzonen gebildet. Es können sowohl der optisch aktive Bereich als auch der optisch inaktive Bereich ein oder mehrere Heizzonen aufweisen. Ziel ist es, durch die Verwendung von mehreren Heizzonen eine möglichst konstante Temperaturverteilung im gesamten Spiegelkörper zu erreichen.

Gemäß einer weiteren Ausführungsform des Verfahrens werden in dem optisch aktiven Bereich zwischen 3 und 10**,** bevorzugt zwischen 4 und 9 Heizzonen und/oder in dem optisch inaktiven Bereich zumindest eine Heizzone gebildet. Im Allgemeinen reicht diese Anzahl von Heizzonen aus, um eine konstante Temperatur im gesamten Spiegelkörper zu erreichen. Beispielsweise können auf der Vorderseite des Spiegels sieben Heizzonen, auf der Seite des Spiegels zwei Heizzonen und auf der Rückseite des Spiegels fünf Heizzonen gebildet werden. Insgesamt ergeben sich damit vierzehn Heizzonen.

Gemäß einer weiteren Ausführungsform des Verfahrens umfasst der Spiegel einen Spiegelkörper, welcher an seiner Stirnseite den optisch aktiven Bereich aufweist, wobei ein den optisch aktiven Bereich umfassender, ringförmiger Randbereich, eine Mantelfläche des Spiegelkörpers und/oder eine der Stirnseite gegenüberliegende Stirnseite den optisch inaktiven Bereich aufweist.

Jede Heizzone wird mit einem Temperatursensor zum Erfassen der Temperatur der jeweiligen Heizzone versehen. Durch die Temperatursensoren kann die Temperatur einer jeden Heizzone bestimmt werden. Werden mehrere Temperatursensoren pro Heizzone oder eine Wärmekamera zur Temperaturermittlung einer Heizzone verwendet, dann lässt sich auch die Temperaturverteilung in dieser Heizzone ermitteln. Dabei kann die Wärmekamera insbesondere eine Infrarotkamera sein.

Gemäß einer weiteren Ausführungsform des Verfahrens wird der Spiegel mit einer Einrichtung zur Reduzierung der Spiegeltemperatur zum Kühlen eines Spiegelkörpers des Spiegels versehen. Aufgrund der Beheizung der einzelnen Heizzonen wird die Temperatur des Spiegelkörpers des Spiegels insgesamt erhöht. Um das Temperaturniveau des Spiegelkörpers insgesamt zu senken, kann eine Einrichtung zur Reduzierung der Spiegeltemperatur vorgesehen werden. Dabei kann die Einrichtung zur Reduzierung der Spiegeltemperatur als eine von dem Spiegelkörper beabstandet angeordnete Wärmesenke ausgeführt werden. Alternativ oder zusätzlich kann die Einrichtung zur Reduzierung der Spiegeltemperatur auch als eine Vergrößerung der Oberfläche des Spiegels ausgeführt werden.

Weiter wird ein Verfahren zum Betreiben einer Lithographieanlage vorgeschlagen, wobei die Lithographieanlage zumindest einen Spiegel umfasst, der nach dem Verfahren zur Herstellung des Spiegels, wie beschrieben, hergestellt wird. Das Verfahren zum Betreiben einer Lithographieanlage umfasst den folgenden Schritt. In diesem Schritt wird die jeweilige Heizzone mittels der jeweiligen Heizeinrichtung derart beheizt, dass die Temperatur einer jeden Heizzone konstant bleibt.

Dabei kann eine jeweilige Heizzone gegebenenfalls auf eine vorgegebene Temperatur geheizt werden.

Vorteilhafterweise kann bei der so betriebenen Lithographieanlage die Temperatur des Spiegels in allen Heizzonen des Spiegels und somit im Spiegelvolumen konstant bzw. nahezu konstant gehalten werden. Dadurch können Deformationen des Spiegels bzw. Abbildungsfehler aufgrund einer Erwärmung, insbesondere einer unterschiedlich starken Erwärmung in unterschiedlichen Heizzonen des Spiegels, vermieden bzw. nahezu vermieden werden. Insbesondere können verschiedene Heizzonen unterschiedlich stark vorgeheizt werden, bevor (insbesondere kurz bevor) die Belichtung des Wafers der Lithographieanlage einsetzt und damit die Erwärmung des Spiegels durch die Strahlung der Lithographieanlage für die Belichtung einsetzt.

Der Ausdruck "die Temperatur einer jeden Heizzone bleibt konstant" bedeutet, dass die Temperaturdifferenz, die sich beim erstmaligen Einschaltung der Belichtung des Wafers als auch bei einer Umschaltung zwischen zwei verschiedenen Beleuchtungssettings ergibt, kleiner 15K, bevorzugt kleiner 5K und noch weiter bevorzugt kleiner 1K ist.

Gemäß einer Ausführungsform des Verfahrens wird jede Heizzone unabhängig von einer jeweils anderen Heizzone beheizt. Dadurch kann sichergestellt werden, dass jede Heizzone individuell so geheizt werden kann, dass die Temperatur des Spiegelkörpers insgesamt in allen Heizzonen konstant bleibt.

Gemäß einer weiteren Ausführungsform des Verfahrens erfolgt das Beheizen für eine oder mehrere der Heizzonen zeitlich variabel. Vorteilhafterweise kann die Beheizung der Heizzonen je nach Bedarf angepasst werden, um die Temperatur des Spiegels insbesondere des gesamten Spiegelkörpers konstant zu halten.

Gemäß einer weiteren Ausführungsform des Verfahrens erfolgt das Beheizen der Heizzonen in einem Belichtungsbetrieb der Lithographieanlage. Die Heizzonen können ferner bereits vor dem Start der Belichtung und/oder nach dem Start der Belichtung beheizt werden.

Gemäß einer weiteren Ausführungsform des Verfahrens werden die Heizzonen vor dem Belichtungsbetrieb vorgeheizt. Die Heizzonen können unterschiedlich stark vorgeheizt werden, bevor die Belichtung des Wafers der Lithographieanlage einsetzt und damit auch die Erwärmung des Spiegels durch die Strahlung der Lithographieanlage für die Belichtung einsetzt. Dadurch wird erreicht, dass es zu keinen signifikanten Temperatursprüngen auf bzw. in dem Spiegel kommt, wenn die Belichtung des Wafers gestartet wird. Der Wärmeeintrag in den Heizzonen kann zu jedem beliebigen Zeitpunkt angepasst werden, um die optimale optische Performance zu erreichen.

Gemäß einer weiteren Ausführungsform des Verfahrens beheizt zumindest eine Heizeinrichtung die entsprechende Heizzone mit einem Muster. Vorteilhafterweise ist das Muster genau entsprechend zu der Wärmestromverteilung, so dass die Temperatur innerhalb der Heizzone konstant gehalten werden kann.

Gemäß einer weiteren Ausführungsform des Verfahrens weist das Muster ein Ringprofil oder einen Teil eines Ringprofils auf. Vorteilhafterweise lässt sich mit der Beheizung mit einem solchen Muster die Temperatur von einer oder mehrerer Heizzonen bzw. von dem Spiegelkörper konstant halten.

Der mit dem Verfahren hergestellte Spiegel für eine Lithographieanlage weist mehrere Heizzonen, welche in Abhängigkeit von einer zu erwartenden Wärmestromverteilung gebildet sind, und mehrere Heizeinrichtungen auf, wobei jeder Heizzone eine Heizeinrichtung zum Beheizen der jeweiligen Heizzone in Abhängigkeit von einer erfassten Temperatur der jeweiligen Heizzone oder der zu erwartenden Wärmestromverteilung auf dem Spiegel zugeordnet ist.

Vorteilhafterweise kann die Temperatur in allen Heizzonen des Spiegels konstant bzw. nahezu konstant gehalten werden. Dadurch können Deformationen des Spiegels bzw. Abbildungsfehler aufgrund einer Erwärmung, insbesondere einer unterschiedlich starken Erwärmung in unterschiedlichen Heizzonen des Spiegels, vermieden bzw. nahezu vermieden werden. Insbesondere können verschiedene Heizzonen unterschiedlich stark vorgeheizt werden, bevor die Belichtung des Wafers der Lithographieanlage und damit die Erwärmung des Spiegels einsetzt.

Gemäß einer Ausführungsform weist zumindest eine Heizeinrichtung einen Wärmestrahler und/oder einen Heizwiderstand auf. Vorteilhafterweise kann die Heizeinrichtung die entsprechende Heizzone des Spiegels mittels Wärmestrahlen und/oder mittels eines Heizwiederstands beheizen.

Der hergestellte Spiegel umfasst einen Temperatursensor pro Heizzone zum Erfassen einer Temperatur einer jeweiligen Heizzone. Vorteilhafterweise kann die Temperatur einer Heizzone mit einem Temperatursensor gemessen werden.

Gemäß einer weiteren Ausführungsform umfasst der herzustellende Spiegel einen Spiegelkörper und eine Einrichtung zur Reduzierung der Spiegeltemperatur zum Kühlen des Spiegelkörpers. Vorteilhafterweise kann mittels der Einrichtung zur Reduzierung der Spiegeltemperatur das Temperaturniveau des Spiegelkörpers gesenkt werden.

Gemäß einer weiteren Ausführungsform weist die Einrichtung zur Reduzierung der Spiegeltemperatur eine von dem Spiegelkörper beabstandet angeordnete Wärmesenke auf. Dabei kann über eine Gasatmosphäre und/oder über Wärmestrahlung Wärme von dem Spiegelkörper auf die Wärmesenke übertragen werden. Vorteilhafterweise stehen der Spiegelkörper und die Wärmesenke nicht in mechanischem Kontakt miteinander, um einen mechanischen Kontakt zwischen Wärmesenke und Spiegelkörper zu vermeiden, so dass beispielsweise keine Vibrationen von der Wärmesenke auf den Spiegelkörper übertragen werden können. Gemäß einer weiteren Ausführungsform weist der Spiegelkörper mehrere Zonen auf. Weiter ist die Wärmesenke in mehrere Segmente aufgeteilt, um die einzelnen Zonen separat zu kühlen. Vorteilhafterweise können die einzelnen Segmente derart angeordnet werden, dass in dem Spiegelkörper ein einheitliches Temperaturniveau erreicht werden kann.

Gemäß einer weiteren Ausführungsform weist die Einrichtung zur Reduzierung der Spiegeltemperatur einen Bereich des Spiegels auf, bei welchem eine Oberfläche aufgrund der Form der Oberfläche im Vergleich zu einer glatten Oberfläche vergrößert ist. Vorteilhafterweise kann der Spiegel umso besser Wärme abgeben, je größer seine Oberfläche ist.

Die für die vorgeschlagenen Verfahren beschriebenen Ausführungsformen und Merkmale gelten für den hergestellten Spiegel entsprechend und umgekehrt. Der hergestellte Spiegel kann in einem Projektionssystem für eine Lithographieanlage eingesetzt werden.

Die Lithographieanlage weist den hergestellten Spiegel, wie beschrieben, und/oder ein Projektionssystem mit dem hergestellten Spiegel auf. Insbesondere kann die Lithographieanlage auch mehrere Spiegel, wie beschrieben, aufweisen. Weitere mögliche Implementierungen der Erfindung umfassen auch nicht explizit genannte Kombinationen von zuvor oder im Folgenden bezüglich der Ausführungsbeispiele beschriebenen Merkmale oder Ausführungsformen. Dabei wird der Fachmann auch Einzelaspekte als Verbesserungen oder Ergänzungen zu der jeweiligen Grundform der Erfindung hinzufügen. Die Erfindung wird durch die beigefügten Ansprüche definiert.

Vorteilhafte Ausgestaltungen und Aspekte der Erfindung sind Gegenstand der Unteransprüche sowie der im Folgenden beschriebenen Ausführungsbeispiele der Erfindung. Im Weiteren wird die Erfindung anhand von bevorzugten Ausführungsformen unter Bezugnahme auf die beigelegten Figuren näher erläutert.
Fig. 1 zeigt eine schematische Ansicht einer EUV-Lithographieanlage;
Fig. 2 zeigt einen Vergleich des RMS der Deformation der optischen Fläche zweier Spiegel;
Fig. 3 zeigt einen weiteren Vergleich des RMS der Deformation der optischen Fläche zweier Spiegel;
Fig. 4 zeigt ein Prinzip des Vorheizens;
Fig. 5A, 5B und 5C zeigen verschiedene Wärmestromverteilungen eines Spiegels;
Fig. 6 zeigt einen Spiegel mit mehreren Heizzonen;
Fig. 7 zeigt einen Schnitt VII - VII aus Fig. 6;
Fig. 8 zeigt den Spiegel aus Fig. 6 und 7 in der Umgebung eines Objektivs einer Lithographieanlage;
Fig. 9 zeigt eine schematische Darstellung eines Spiegels mit verschiedenen Heizzonen;
Fig. 10 zeigt einen Schnitt X - X aus Fig. 9;
Fig. 11 zeigt mehrere Heizzonen auf der Rückseite des in Fig. 9 und 10 dargestellten Spiegels;
Fig. 12 zeigt ein Ablaufdiagramm eines Verfahrens zum Herstellen eines in den Fig. 6, 7, 9, 10 und 11 dargestellten Spiegels;
Fig. 13 zeigt einen Spiegel in der Umgebung eines Objektivs einer Lithographieanlage wie in Fig. 8 mit einer Wärmesenke;
Fig. 14 zeigt den Spiegel in der Umgebung eines Objektivs einer Lithographieanlage aus Fig. 13 mit einer in mehrere Segmente aufgeteilten Wärmesenke;
Fig. 15 zeigt eine vergrößerte Darstellung des Bereichs XV des Spiegels aus Fig. 13; und
Fig. 16 zeigt eine vergrößerte Darstellung des Bereichs XV des Spiegels aus Fig. 13 mit einer alternativen Oberfläche.

Falls nichts anderes angegeben ist, bezeichnen gleiche Bezugszeichen in den Figuren gleiche oder funktionsgleiche Elemente. Ferner sollte beachtet werden, dass die Darstellungen in den Figuren nicht notwendigerweise maßstabsgerecht sind.

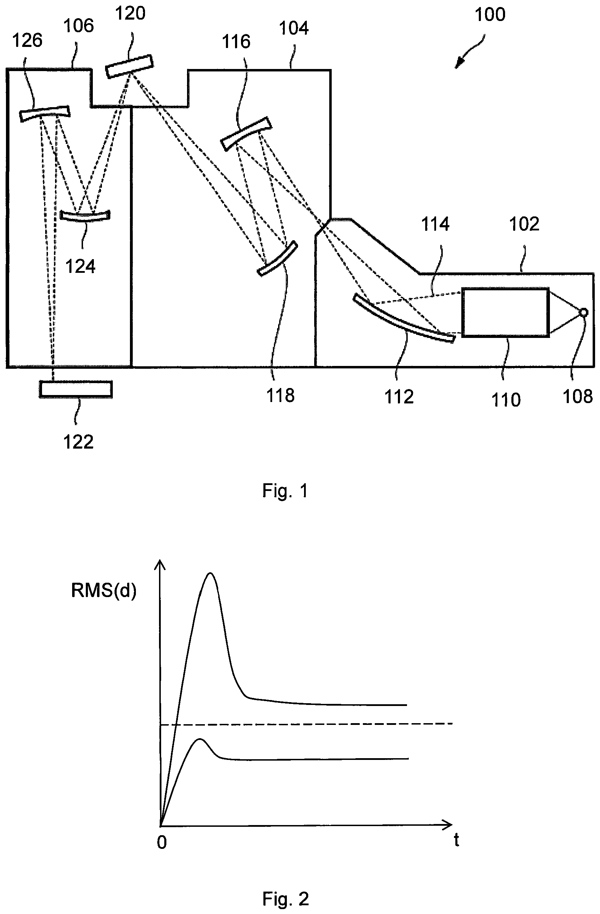

Fig. 1 zeigt eine schematische Ansicht einer EUV-Lithographieanlage 100 gemäß einer Ausführungsform, welche ein Strahlformungssystem 102, ein Beleuchtungssystem 104 und ein Projektionssystem 106 umfasst. Das Strahlformungssystem 102, das Beleuchtungssystem 104 und das Projektionssystem 106 sind jeweils in einem Vakuum-Gehäuse vorgesehen, welches mit Hilfe einer nicht näher dargestellten Evakuierungsvorrichtung evakuiert wird. Die Vakuum-Gehäuse sind von einem nicht näher dargestellten Maschinenraum umgeben, in welchem die Antriebsvorrichtungen zum mechanischen Verfahren bzw. Positionieren einer oder mehrerer optischer Elemente vorgesehen sind. Ferner können auch elektrische Steuerungen und dergleichen in diesem Maschinenraum vorgesehen sein.

Das Strahlformungssystem 102 weist eine EUV-Lichtquelle 108, einen Kollimator 110 und einen Monochromator 112 auf. Als EUV-Lichtquelle 108 kann beispielsweise eine Plasmaquelle oder ein Synchrotron vorgesehen sein, welche Strahlung im EUV-Bereich (extrem ultravioletten Bereich), also z.B. im Wellenlängenbereich von 0,1 nm bis 30 nm aussenden. Die von der EUV-Lichtquelle 108 austretende Strahlung wird zunächst durch den Kollimator 110 gebündelt, wonach durch den Monochromator 112 die gewünschte Betriebswellenlänge herausgefiltert wird. Somit passt das Strahlformungssystem 102 die Wellenlänge und die räumliche Verteilung des von der EUV-Lichtquelle 108 abgestrahlten Lichts an. Die von der EUV-Lichtquelle 108 erzeugte EUV-Strahlung 114 weist eine relativ niedrige Transmissivität durch Luft auf, weshalb die Strahlführungsräume im Strahlformungssystem 102, im Beleuchtungssystem 104 und im Projektionssystem 106 evakuiert sind.

Das Beleuchtungssystem 104 weist im dargestellten Beispiel einen ersten Spiegel 116 und einen zweiten Spiegel 118 auf. Diese Spiegel 116, 118 können beispielsweise als Facettenspiegel zur Pupillenformung ausgebildet sein und leiten die EUV-Strahlung 114 auf eine Photomaske 120.

Die Photomaske 120 ist ebenfalls als reflektives optisches Element ausgebildet und kann außerhalb der Systeme 102, 104, 106 angeordnet sein. Die Photomaske 120 weist eine Struktur auf, welche mittels des Projektionssystems 106 verkleinert auf einen Wafer 122 oder dergleichen abgebildet wird. Hierzu weist das Projektionssystem 106 im Strahlführungsraum beispielsweise einen dritten Spiegel 124 und einen vierten Spiegel 126 auf. Es sollte beachtet werden, dass die Anzahl der Spiegel der EUV-Lithographieanlage 100 nicht auf die dargestellte Anzahl beschränkt ist, und es können auch mehr oder weniger Spiegel vorgesehen sein. Des Weiteren sind die Spiegel i.d.R. an ihrer Vorderseite zur Strahlformung gekrümmt.

Die Projektionsoptik im Projektionssystem 106 ist mit den beiden Spiegeln 124, 126 extrem vereinfacht dargestellt. Die Projektionsoptik weist bevorzugt mehrere Spiegel auf, z.B. 6 bis 9 Spiegel. Der vorderste Spiegel 124 einer Projektionsoptik im Strahlengang nach dem Retikel 120 heizt sich besonders stark auf. Dies mitunter deswegen, weil das Licht auf diesen senkrecht auftrifft (Engl.: Normal Incident Mirror). Deswegen wird im Folgenden auf den vordersten Spiegel 124 (im Weiteren nur Spiegel 124) der Projektionsoptik eingegangen.

Fig. 2 zeigt einen Vergleich der Deformation zweier Spiegel 124. Verglichen werden ein Spiegel 124 der nicht thermisch manipuliert ist und ein Spiegel 124 bei dem die Methode der "Advanced Wavefront Correction" angewendet wird. Dabei bedeutet "Advanced Wavefront Correction", dass eine thermoelastische Verformung des Spiegels 124 erfolgt, um Abbildungsfehler auszugleichen. In Fig. 2 ist das quadratische Mittel (Engl.: root-mean-square, RMS) der Abweichung d der Oberflächendeformation der optischen Fläche von ihrer Deformation zum Zeitpunkt t = 0 gegen die Zeit t aufgetragen. Die Deformation zum Zeitpunkt t = 0 ist hier auf Null gesetzt. Je größer die Verformung ist, umso größer ist auch die Abweichung d. Zum Zeitpunkt t = 0 setzt die Belichtung durch die EUV-Strahlung der beiden zu vergleichenden Spiegel 124 ein. Die obere Kurve in Fig. 2 ist die Kurve des nicht thermisch manipulierten Spiegels. Wie man der Fig. 2 entnehmen kann, kommt es beim nicht thermisch manipulierten Spiegel nach dem Einsetzten der EUV-Belichtung zu einer starken Verformung bzw. einer starken Verformungsänderung. Die starke Verformung bzw. Verformungsänderung entsteht aufgrund der Ausbildung von Wärmestrompolen. Wie die untere Kurve zeigt, kann die Verformung bzw. die Verformungsänderung mit der Methode der "Advanced Wavefront Correction" verkleinert werden. Somit kann die untere Kurve unter einem maximal zulässigen Wert des RMS(d) bleiben, welcher in Fig. 2 durch die gestrichelte Linie symbolisiert wird.

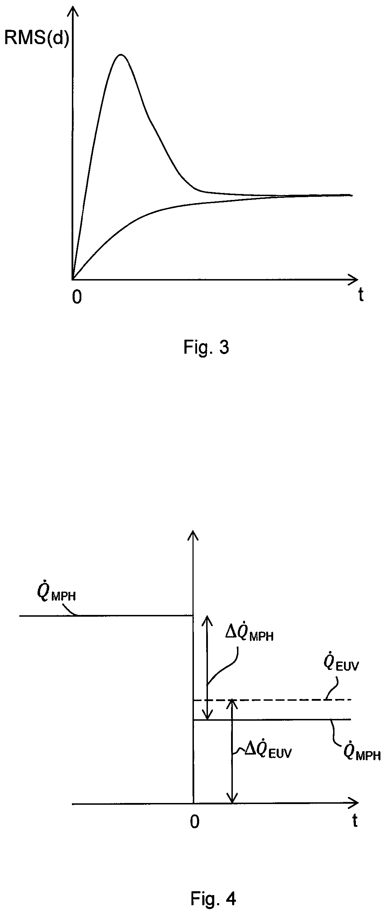

Fig. 3 zeigt einen weiteren Vergleich der Deformation zweier Spiegel 124. Gezeigt wird das quadratische Mittel (RMS) der Abweichung d der Oberflächendeformation der optischen Fläche von ihrer Deformation zum Zeitpunkt t = 0 von einem Spiegel 124 der nicht vorgeheizt wird (obere Kurve) und von einem Spiegel 124 der vorgeheizt wird (untere Kurve). Dabei bedeutet "vorgeheizt", dass der Spiegel 124 bevor die EUV-Belichtung des Spiegels 124 einsetzt, also vor dem Zeitpunkt t = 0, geheizt wird, damit der Temperaturunterschied, wenn die Belichtung startet, nicht so groß ist. Zu sehen ist eine anfängliche starke Verformung bzw. Verformungsänderung des Spiegels 124 der nicht vorgeheizt wird. Wird der Spiegel 124 vorgeheizt, dann ist die anfängliche Verformung bzw. Verformungsänderung des Spiegels 124 wesentlich schwächer.

Fig. 4 zeigt ein Prinzip des Vorheizens. Bevor ein Spiegel 124 belichtet wird, d.h. im Zeitbereich t < 0 wird der Spiegel 124 mit einem Wärmestrom *Q̇* _{MPH} (Engl.: mirror pre-heating, MPH) beaufschlagt. Zum Zeitpunkt t = 0 setzt die Belichtung des Spiegels 124 ein. Durch die Belichtung des Spiegels 124 kommt es zu einem Wärmestrom *Q̇* _{EUV} (Engl.: extreme ultraviolet, EUV) auf den Spiegel 124. Damit der Wärmestrom auf den Spiegel 124 immer konstant ist, wird der Wärmestrom *Q̇* _{MPH} zum Zeitpunkt t = 0 um den Betrag Δ*Q̇* _{MPH} verringert. Der Wärmestrom *Q̇*_{EUV} steigt um Δ*Q̇* _{EUV}. Der vom Spiegel 124 absorbierte Gesamtwärmestrom ändert sich derart, dass sich die Spiegeltemperatur nach Möglichkeit nicht ändert.

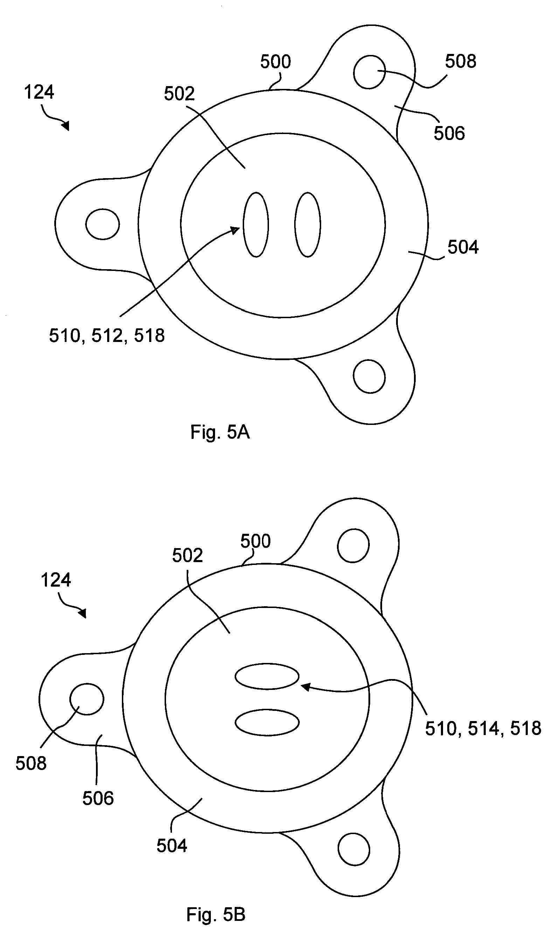

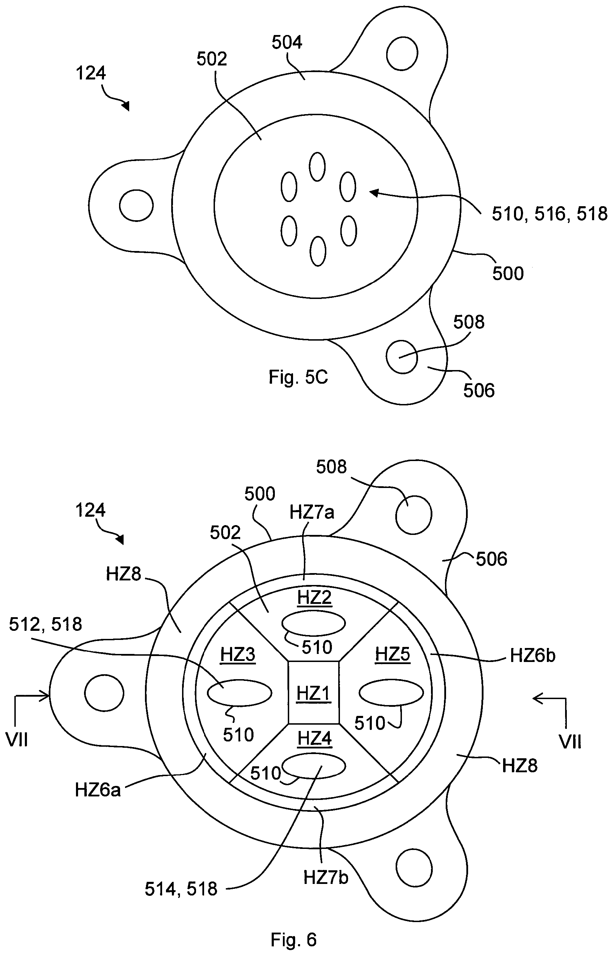

Die Figuren 5A, 5B und 5C zeigen EUV-Wärmestromverteilungen 518 auf einem Spiegel 124. Der Spiegel 124 weist einen Spiegelkörper 500 auf. Auf dem Spiegelkörper 500 ist ein optisch aktiver Bereich 502 und ein optisch inaktiver Bereich 504 zu sehen. Dabei ist der optisch aktive Bereich 502 der Bereich des Spiegels 124 bei dem die EUV-Strahlung reflektiert wird. Weiter weist der in den Figuren 5A, 5B und 5C dargestellte Spiegel 124 drei Halteeinrichtungen 506 auf, wobei durch jede Halteeinrichtung 506 eine Bohrung 508 zum Befestigen des Spiegels 124 an einem Spiegelhalter führt.

Je nachdem, um welche Struktur es sich handelt, die auf dem Wafer 122 abgebildet werden soll, ergibt sich eine unterschiedliche Wärmestromverteilung 518 auf dem Spiegel 124. Fig. 5A zeigt einen Spiegel 124 mit einer X-Dipol 512 Wärmestromverteilung 518 und Fig. 5B zeigt einen Spiegel 124 mit einer Y-Dipol 514 Wärmestromverteilung 518. Weiter zeigt Fig. 5C einen Spiegel 124 mit einer "DRAM 516 Wärmestromverteilung 518", d.h. mit einer Wärmestromverteilung 518, die bei der Belichtung eines Wafers 122 zur Herstellung von DRAM entsteht. Durch Berechnungen und/oder Simulationen anhand von Modellen kann ermittelt werden, welche Wärmestromverteilung 518 auf dem Spiegel 124 zu erwarten ist. Die zu erwartende Wärmestromverteilung 518 ist diejenige Wärmestromverteilung 518, die anhand von Modellen sowie Berechnungen und/oder Simulationen zu diesen Modellen ermittelt wird.

Aufgrund der Kenntnis der zu erwartenden Wärmestromverteilung 518 können passend zu dieser Wärmestromverteilung 518 Heizzonen HZ gewählt werden. Fig. 6 zeigt einen Spiegel 124 mit mehreren Heizzonen HZ1 - HZ8. Wie in Fig. 6 zu sehen, ist der optisch aktive Bereich 502 in fünf Heizzonen HZ1 - HZ5 aufgeteilt. Die Heizzonen HZ6 - HZ8 liegen im optisch inaktiven Bereich 504. Dabei sind die Heizzone HZ6 und die Heizzone HZ7 in einem Ring um den optisch aktiven Bereich 502 angeordnet. Die Heizzone HZ6 befindet sich rechts und links neben dem optisch aktiven Bereich 502. Im Gegensatz dazu befindet sich die Heizzone HZ7 oberhalb und unterhalb des in Fig. 6 dargestellten optisch aktiven Bereichs 502. Die Heizzone HZ6 kann in zwei Heizzonen HZ6a und HZ6b aufgeteilt werden und die Heizzone HZ7 kann in zwei Heizzonen HZ7a und HZ7b aufgeteilt werden. Die Heizzone HZ8 ist als äußerer Ring um den Ring der Heizzonen HZ6 und HZ7 ausgebildet.

Durch die Kenntnis der zu erwartenden Wärmestromverteilung 518 können die Heizzonen HZ1 - HZ8 so auf dem Spiegel gebildet werden, dass Wärmestrompole 510, d.h. Gebiete mit besonders hoher Temperatur, geeignet auf die Heizzonen HZ1 - HZ8 verteilt werden. Vorliegend ist beispielhaft eine Wärmestromverteilung 518 mit einem X- und einem Y-Dipol 512, 514 gezeigt, welche sich aus einem waferspezifischen Beleuchtungssetting ergibt. Jeder Wärmestrompol 510 ist genau einer Heizzone HZ2 - HZ5 zugeordnet. Die restlichen Heizzonen sind dagegen "kalte" Heizzonen, beinhalten also keinen Wärmestrompol 510 im Belichtungsbetrieb.

Damit lässt sich, durch eine entsprechende Beheizung der einzelnen Heizzonen HZ1 - HZ8, eine konstante Temperaturverteilung in dem Spiegelkörper 500 des Spiegels 124 realisieren. "Konstant" heißt hier, dass die mit einem Temperatursensor erfasste Temperatur einer Heizzone innerhalb einer bestimmten Temperaturdifferenz bleibt. Die maximale Temperaturdifferenz, die sich beim erstmaligen Einschaltung der Belichtung des Wafers vor und nach dem Einschalten als auch bei einer Umschaltung zwischen zwei verschiedenen Beleuchtungssettings ergeben darf, ist kleiner als 15K, bevorzugt kleiner als 5K und noch weiter bevorzugt kleiner als 1K. Dabei ist eine Temperaturdifferenz innerhalb des optisch aktiven Bereichs 502 kleiner als 3 K, bevorzugt kleiner als 0.5 K insbesondere bevorzugt kleiner als 0.1 K. Dadurch kommt es nicht zu thermisch bedingten Abbildungsfehlern des Spiegels 124, die oberhalb eines spezifizierten Wertes liegen.

Insbesondere können die einzelnen Heizzonen HZ1 - HZ8 getrennt voneinander beheizt werden. Zudem können die einzelnen Heizzonen HZ1 - HZ8 zeitlich variabel beheizt werden, d.h. die einzelnen Heizzonen HZ1 - HZ8 können z.B. vorgeheizt werden.

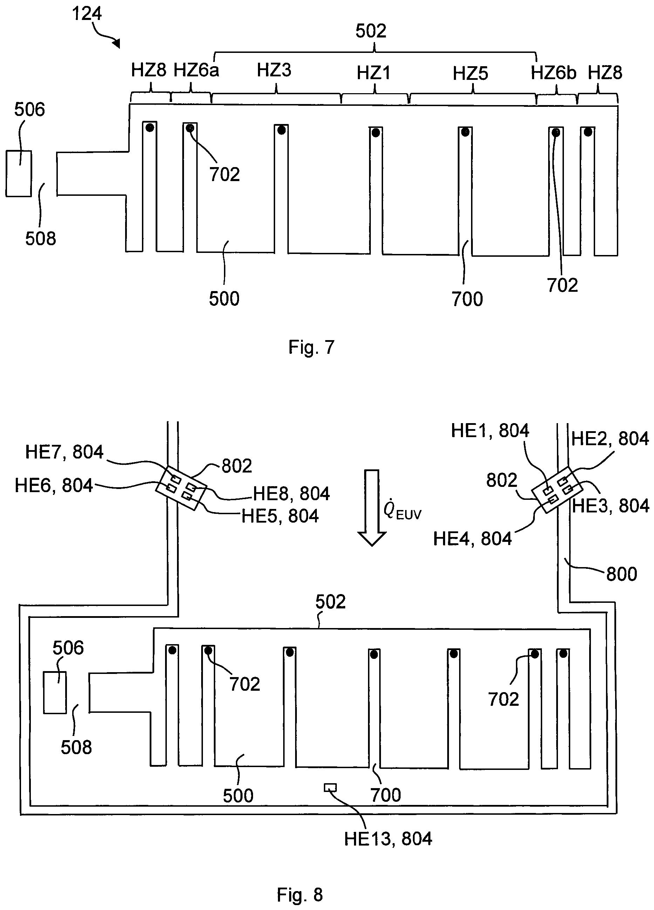

Fig. 7 zeigt einen Schnitt VII - VII aus Fig. 6. Zu sehen ist der Spiegel 124 mit dem Spiegelkörper 500. Der Spiegelkörper 500 kann als Monolith ausgebildet sein. Auf der linken Seite der Fig. 7 ist eine Halteeinrichtung 506 mit einer zugehörigen Bohrung 508 dargestellt. Im Spiegelkörper 500 befinden sich einige Bohrungen 700 in Form von Sacklochbohrungen, welche von einer rückseitigen Stirnseite (gegenüberliegend der vorderseitigen Stirnseite mit dem optisch aktiven Bereich 502) in den Spiegelkörper 500 eingebracht sind. In den Bohrungen 700 befinden sich Temperatursensoren 702. Die Temperatursensoren 702 sind nahe an der jeweiligen Heizzone HZ1 - HZ8 angebracht, damit sie die Temperatur der jeweiligen Heizzone HZ1 - HZ8 möglichst genau messen können.

Wie in Fig. 7 gezeigt, ist bei jeder Heizzone HZ1 - HZ8 ein Temperatursensor 702 vorgesehen. Damit kann für jede Heizzone HZ1 - HZ8 eine Temperatur bestimmt werden. Alternativ können auch mehrere Temperatursensoren 702 pro Heizzone HZ1 - HZ8 verwendet werden. Mit mehreren Temperatursensoren 702 für eine Heizzone HZ1 - HZ8 lässt sich ein Temperaturprofil für diese Heizzone HZ1 - HZ8 erstellen. Durch die Kenntnis eines Temperaturprofils einer Heizzone HZ1 - HZ8 kann diese Heizzone HZ1 - HZ8 mit einem entsprechenden Heizmuster beheizt werden. Ein solches Vorgehen kann Temperaturschwankungen innerhalb einer Heizzone HZ1 - HZ8 noch besser vermeiden. Ein Heizmuster kann sich aber auch über mehrere Heizzonen HZ1 - HZ8 erstrecken.

Alternativ oder zusätzlich zu den Temperatursensoren 702 kann eine Wärmekamera die Temperaturverteilung für eine oder mehrere Heizzonen HZ1 - HZ8 erfassen. Auch mit einer Wärmekamera kann man für eine oder mehrere Heizzonen HZ1 - HZ8 ein Temperaturprofil erstellen.

Fig. 8 zeigt den Spiegel 124 aus Fig. 6 und 7 in der Umgebung eines Objektivs einer Lithographieanlage. Weiter ist ein Gehäuse 800 dargestellt. Der Strahlengang befindet sich innerhalb des Gehäuses 800 im sogenannten Mini-Environment. Die Strahlung die während der Belichtung eines Wafers 122 auf den Spiegel 124 trifft bringt einen Wärmestrom *Q̇* _{EUV} mit sich. Dieser trifft auf den optisch aktiven Bereich 502 des Spiegels 124 und erwärmt diesen, da die Strahlung nicht vollständig reflektiert wird. Damit es über die Zeit nicht zu thermisch bedingten Verformungen des Spiegels 124 kommt, soll die Temperatur des gesamten Spiegels 124, d.h. alle Temperaturen der einzelnen Heizzonen HZ1 - HZ8, konstant sein. Dazu werden die einzelnen Heizzonen HZ1 - HZ8 mit den jeweiligen Heizeinrichtungen HE1 - HE8, insbesondere mit Wärmestrahlern 804, individuell beheizt, so dass alle Heizzonen HZ1 - HZ8 des Spiegels 124 vor, während und nach einer Belichtung des Wafers 122 die gleiche Temperatur aufweisen (nichtdestotrotz können die Temperaturen in unterschiedlichen Heizzonen HZ1 - HZ8 unterschiedlich sein). Die einzelnen Heizeinrichtungen HE1 - HE8 können in Heizvorrichtungen 802 zusammengefasst werden. In Fig. 8 sind zwei Heizvorrichtungen 802 dargestellt. Die erste Heizvorrichtung 802 enthält die Heizeinrichtungen HE1 - HE4 und die zweite Heizvorrichtung 802 enthält die Heizeinrichtungen HE5 - HE8. Jeder Heizzone HZ1 - HZ8 ist eine Heizeinrichtung HE1 - HE8 zugeordnet. Weiter ist die Anordnung der Heizvorrichtungen 802 auch an der Seite oder an der Rückseite des Spiegels 124 möglich. Weiter kann der Spiegelkörper 500 für die von den Heizvorrichtungen 802 emittierte Wärme transparent oder teiltransparent sein, und die Wärme kann an der optischen Fläche absorbiert werden.

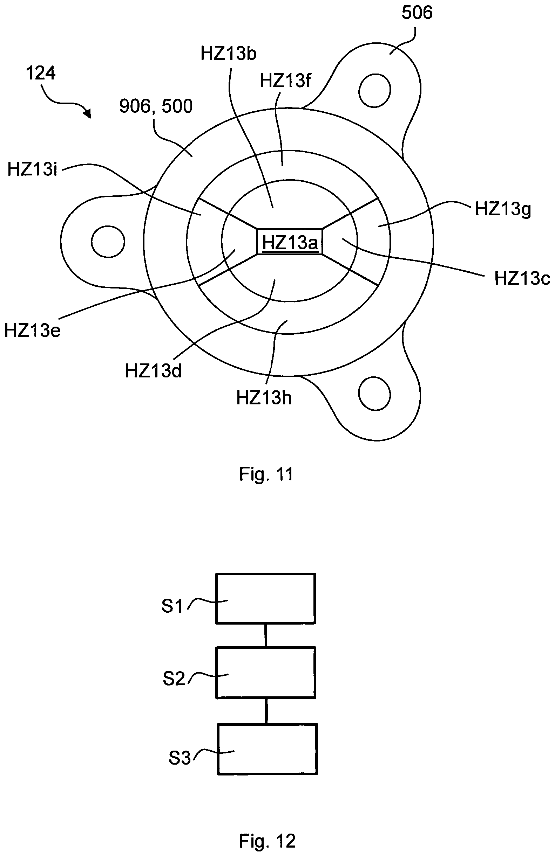

Unterhalb des Spiegelkörpers 500 ist ebenfalls eine Heizeinrichtung HE13 dargestellt, um die rückseitige Stirnseite (gegenüberliegend der vorderseitigen Stirnseite mit dem optisch aktiven Bereich 502) zu beheizen. Die Heizeinrichtung HE13 kann aus mehreren einzelnen Heizeinrichtungen bestehen um beispielsweise eine Rückseite 906 des Spiegels 124 zu beheizen, wie sie in Fig. 11 dargestellt ist.

Die Heizeinrichtungen HE1 - HE13 können einen VCSEL (Engl.: Vertical cavity surface emitting laser) aufweisen. Dabei können insbesondere VCSEL verwendet werden, welche Strahlung im Infrarotbereich emittieren.

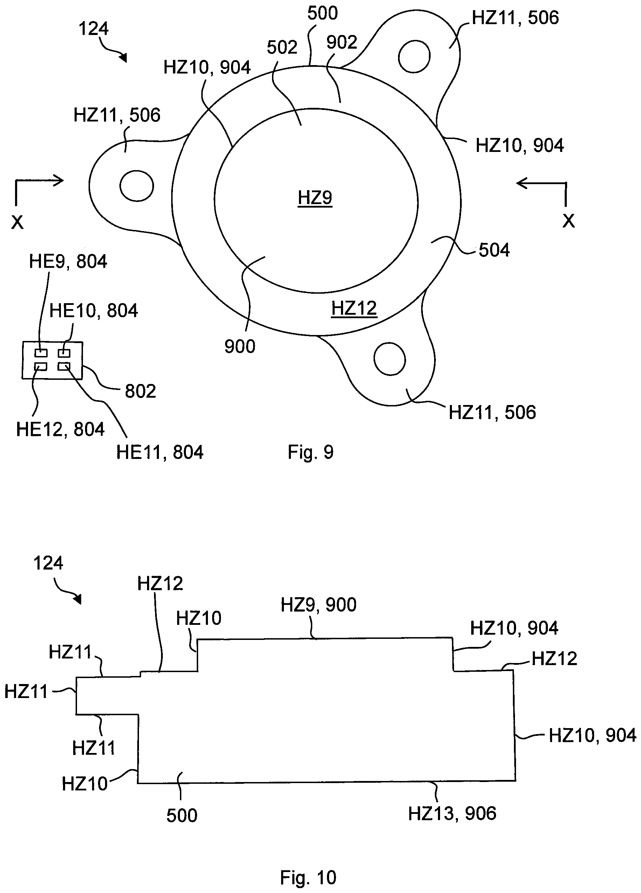

Fig. 9 und Fig. 10 zeigen eine schematische Darstellung eines Spiegels 124 mit verschiedenen Heizzonen HZ9 - HZ13. In Fig. 9 sieht man eine Draufsicht auf die Stirnseite 900 des Spiegels 124. Die Heizzone HZ9 wird durch den optisch aktiven Bereich 502 begrenzt. Wie zuvor beschrieben, kann der optisch aktive Bereich 502 auch in mehrere Heizzonen aufgeteilt sein. Die Mantelfläche 904 bildet eine Heizzone HZ10, die Halteeinrichtungen 506 bilden eine Heizzone HZ11 und ein ringförmiger Randbereich 902 bildet eine Heizzone HZ12. In einer lediglich schematisch dargestellten Heizvorrichtung 802 sind vier Heizeinrichtungen HE9 - HE12 dargestellt, welche die entsprechenden Heizzonen HZ9 - HZ12 beheizen können.

Fig. 10 zeigt einen Schnitt X - X aus Fig. 9. In dieser Darstellung ist die der Stirnseite 900 des Spiegels 124 gegenüberliegende Stirnseite 906 zu sehen. Die Stirnseite 906, d.h. die Rückseite des Spiegels 124, bildet eine Heizzone HZ13.

Demnach ist bevorzugt, nicht nur den optisch aktiven Bereich 502 zu beheizen, sondern auch ein oder mehrere andere Bereiche. Ziel ist eine möglichst konstante Temperatur im gesamten Spiegelkörper 500. Eine Änderung der Temperatur mit dem Ort oder mit der Zeit ist unerwünscht, da dies zu Deformationen des Spiegels 124 führen kann. Dabei können die Heizzonen HZ9 - HZ13 alle gemeinsam oder nur zum Teil geheizt werden. Sie können gleichzeitig als auch nacheinander oder in unterschiedlichen Zeitintervallen geheizt werden. Dabei können sie mit konstanten Wärmeströmen als auch mit einem speziellen Wärmestrommuster beheizt werden. Sie können vor der Belichtung des Wafers 122, während der Belichtung des Wafers 122 und nach der Belichtung des Wafers 122 beheizt werden. Jede Heizzone HZ9 - HZ13 wird mit einer separaten Heizeinrichtung HE9-HE13 beheizt. Es können ein oder mehrere Wärmestrahler 804 pro Heizzone HZ9 - HZ13 verwendet werden. Es können mehrere Heizzonen HZ9 - HZ13 mit nur einer Heizvorrichtung 802 mit Wärme beaufschlagt werden. Das Heizen der Heizzonen HZ9 - HZ13 kann durch Wärmestrahler als auch durch Wärmewiderstände erfolgen. Für die Wärmestrahler können IR-Heizköpfe verwendet werden.

Fig. 11 zeigt mehrere Heizzonen HZ13a - HZ13i auf der Rückseite des in Fig. 9 und 10 dargestellten Spiegels 124. Die Heizzone HZ13 ist demnach in mehrere einzelne Heizzonen HZ13a - HZ13i unterteilt. Der Spiegel 124 kann auf seiner Rückseite 906 keine, eine oder mehrere Heizzonen HZ13a - HZ13i aufweisen. Dabei werden die Heizzonen HZ13a - HZ13i wie zuvor beschrieben einzeln geheizt, um eine möglichst konstante Temperatur im Spiegelkörper 500 zu erreichen.

Fig. 12 zeigt ein Ablaufdiagramm eines Verfahrens zum Herstellen eines in den Fig. 6, 7, 9, 10 und 11 dargestellten Spiegels 124. In einem ersten Schritt S1 wird eine zu erwartende Wärmestromverteilung 518 auf dem Spiegel 124 ermittelt.

Dabei kommt es darauf an, welche Struktur mit dem Projektionssystem 106 auf dem Wafer 122 abgebildet werden soll. Die Ermittlung erfolgt durch Berechnungen und/oder Simulationen anhand von Modellen. Dadurch kann die Wärmestromverteilung 518 auf dem Spiegel 124 abgeschätzt werden. Die zu erwartende Wärmestromverteilung 518 auf dem Spiegel 124 ist diejenige Verteilung, die anhand von Modellen sowie Berechnungen und/oder Simulationen zu diesen Modellen ermittelt wird.

In einem zweiten Schritt S2 werden mehrere Heizzonen HZ1 - HZ13 auf dem Spiegel 124 in Abhängigkeit von der ermittelten Wärmestromverteilung 518 gebildet. Bevorzugt werden die Heizzonen HZ1 - HZ13 auf dem Spiegel 124 so gewählt, dass Gebiete mit besonders hoher Temperatur, sogenannte Wärmestrompole 510, geeignet auf die Heizzonen HZ1 - HZ13 verteilt werden. Durch eine entsprechende Beheizung der einzelnen Heizzonen HZ1 - HZ13, kann dann eine konstante Temperaturverteilung in dem Spiegelkörper 500 des Spiegels 124, sowohl zeitlich gesehen als auch örtlich gesehen, realisiert werden.

In einem dritten Schritt S3 wird eine jeweilige Heizzone HZ1 - HZ13 mit einer jeweiligen Heizeinrichtung HE1 - HE13 zum Beheizen der jeweiligen Heizzone HZ1 - HZ13 versehen. Dabei wird die jeweilige Heizzone in Abhängigkeit von einer erfassten Temperatur der jeweiligen Heizzone HZ1 - HZ13 oder der zu erwartenden Wärmestromverteilung 518 auf dem Spiegel 124 beheizt.

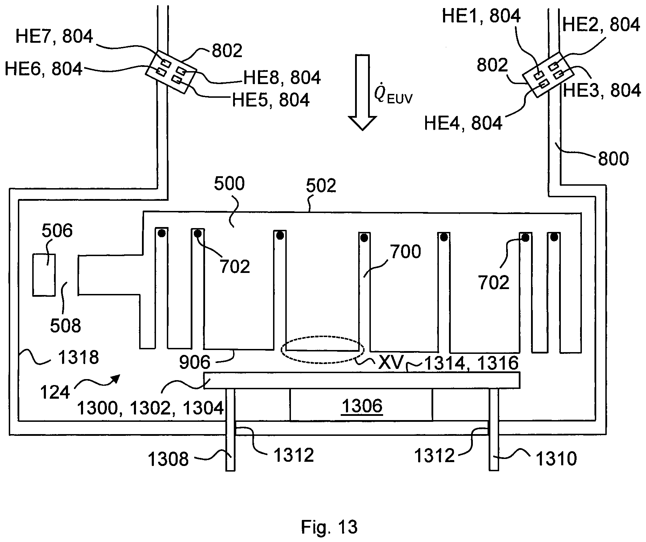

Fig. 13 zeigt einen Spiegel 124 in einem Gehäuse 800, wie er auch in Fig. 8 dargestellt ist. Im Gegensatz zu dem in der Fig. 8 dargestellten Spiegel 124 weist der in Fig. 13 dargestellte Spiegel 124 neben dem Spiegelkörper 500 auch eine Einrichtung 1300 zur Reduzierung der Spiegeltemperatur zum Kühlen des Spiegelkörpers 500 auf. Insgesamt soll im gesamten Spiegelkörper 500 eine möglichst homogene Temperaturverteilung erreicht werden.

Durch das beschriebene Vorheizen des Spiegels 124, d.h. das Beheizen von mehreren Heizzonen HZ1-HZ13, wird die Spiegeltemperatur erhöht. Beispielsweise kann sich das Temperaturniveau des Spiegelkörpers 500 des Spiegels 124 von ca. 45°C auf ca. 65°C erhöhen. Die erhöhte Spiegeltemperatur kann sich nachteilig auf das Spiegel-coating (z.B. Abfolge von Schichten aus Molybdän und Silizium) und den am Spiegel 124 applizierten Klebstoff (z.B. zum Verbinden des Spiegels 124 mit den Temperatursensoren 702 oder den Halteeinrichtungen 506) auswirken. Weiter wirkt sich ein räumlich inhomogener Wärmeausdehnungskoeffizient des Materials des Spiegelkörpers 500 umso stärker aus je höher die Temperatur steigt.

In der Lithographieanlage 100 kann eine Referenz-Temperatur von z.B. 22°C gelten. Die Kühlwassertemperatur der Lithographieanlage 100 beträgt demnach 22°C. Ein Absenken des Temperaturniveaus des Spiegels 124 mittels einer Verringerung der Temperatur des Kühlwassers der Lithographieanlage 100 hätte zur Folge, dass benachbarte Elemente des Spiegels 124 unbeabsichtigt gekühlt würden. Deshalb kann der Spiegel 124 zur Kühlung eine separate Einrichtung 1300 zur Reduzierung der Spiegeltemperatur aufweisen.

Die Einrichtung 1300 zur Reduzierung der Spiegeltemperatur kann eine von dem Spiegelkörper 500 beabstandet angeordnete Wärmesenke 1302 sein. Dabei weist die Wärmesenke 1302 eine niedrigere Temperatur auf als der Spiegelkörper 500. Die Temperatur der Wärmesenke 1302 kann in einem Temperaturbereich von 20°C bis -60°C, 0°C bis -40°C oder -10°C bis -30°C liegen.

Die Wärmesenke 1302 wird an geeigneter Stelle zwischen dem Spiegelkörper 500 und dem Gehäuse 800 positioniert. Wie in Fig. 13 dargestellt, trifft der Wärmestrom *Q̇* _{EUV} mittig auf den Spiegelkörper 500. Dadurch wird sich der Spiegelkörper 500 vor allem in der Mitte erwärmen. Um eine möglichst homogene Temperaturverteilung im gesamten Spiegelkörper zu erreichen, kann die Wärmesenke 1302 mittig zum Spiegelkörper 500 angeordnet werden. Jedoch ist auch an jeder anderen Position zwischen Spiegelkörper 500 und Gehäuse 800 eine Wärmesenke 1302 denkbar.

Wie Fig. 13 zeigt, kann die Wärmesenke 1302 als Platte 1304 ausgebildet sein. Prinzipiell kann die Wärmesenke 1302 eine beliebige Geometrie aufweisen. Weiter kann sich die Platte 1304, wie in Fig. 13 dargestellt, entlang eines Teils der Rückseite 906 des Spiegelkörpers 500 erstrecken. Alternativ kann sich die Platte 1304 auch entlang der gesamten Rückseite 906 des Spiegelkörpers 500 erstrecken.

Es ist vorteilhaft, wenn zwischen dem Spiegelkörper 500 und der Platte 1304 kein mechanischer Kontakt besteht. Dadurch kann eine Übertragung von Vibrationen der Platte 1304 auf den Spiegelkörper 500 vermieden werden. Die Übertragung der Wärme von dem Spiegelkörper 500 zu der Platte 1304 erfolgt über eine Gasatmosphäre und/oder über Wärmestrahlung.

Die Platte 1304 kann am Gehäuse 800 befestigt sein, um von diesem gehalten zu werden. Dabei kann das Gehäuse 800 thermisch zur Platte 1304 isoliert sein. Der Wärmeaustausch kann dann vor allem zwischen dem Spiegelkörper 500 und der Platte 1304 stattfinden.

Weiter kann die Platte 1304 mit einem Peltier-Element 1306 verbunden sein. Das Peltier-Element 1306 kann zudem mit dem Gehäuse 800 verbunden sein. Dadurch kann die Platte 1304 mittels des Peltier-Elements gekühlt werden, wobei die Wärme von der Platte 1304 über das Peltier-Element 1306 auf das Gehäuse 800 übertragen wird. Dabei kann die Platte 1304 sowie auch das Gehäuse 800 aus einem wärmeleitenden Material wie beispielsweise Stahl oder Aluminium gefertigt werden.

Alternativ oder zusätzlich kann die Platte 1304 mittels eines Kühlfluids gekühlt werden. Dabei kann die Temperatur des Kühlfluids an die Temperatur des Spiegelkörpers 500 angepasst werden. Dafür kann ein separater Kühlkreislauf vorgesehen werden. Als Kühlfluid kann beispielsweise Wasser oder Glykol vorgesehen sein. Das Kühlfluid wird mittels einer Zufuhrleitung 1308 zu der Platte 1304 geführt und mittels einer Abfuhrleitung 1310 von der Platte 1304 abgeführt. Weiter kann das Kühlfluid ein Rohrsystem in der Platte 1304 durchströmen, um diese zu kühlen. Alternativ kann das Rohrsystem auch außen an der Platte 1304 angebracht werden. Die Zufuhrleitung 1308 und die Abfuhrleitung 1310 werden jeweils an einer Durchführung 1312 durch das Gehäuse 800 geführt.

Alternativ kann die Platte 1304 auch durch die Zufuhrleitung 1308 und die Abfuhrleitung 1310 gehalten werden. In diesem Fall sind die Zufuhrleitung 1308 und die Abfuhrleitung 1310 stabil ausgeführt, beispielsweise durch ein Material welches ein Metall aufweist. In einer weiteren Alternative können auch Elemente vorgesehen sein, welche durch das Gehäuse 800 durchgeführt werden und die Platte 1304 halten. In diesem Fall können die Zufuhrleitung 1308 und die Abfuhrleitung 1310 lediglich die Funktion haben das Kühlfluid zu leiten.

Alternativ kann die Kühlung der Platte 1304 auch mittels einer Zweiphasenkühlung erfolgen. Dazu kann flüssiges Kohlenstoffdioxid (CO₂) über die Zufuhrleitung 1308 zu der Platte 1304 geführt werden und dort verdampfen. Dabei wird der Platte 1304 die benötigte Verdampfungsenergie entzogen. Dadurch wird die Platte 1304 gekühlt. Das teilweise verdampfte Kohlenstoffdioxid wird dann über die Abfuhrleitung 1310 wieder abgeführt. Die Temperatur des Kohlenstoffdioxids bleibt konstant. Hierdurch kann auch bei Schwankungen der durch die Platte 1304 abgeführten Wärme die Temperatur der Platte 1304 nahezu konstant gehalten werden.

Weiter kann die Oberfläche 1314 der Wärmesenke 1302 derart beschichtet sein, dass sie Wärmestrahlung gut absorbiert. Dazu kann die Oberfläche 1314 der Wärmesenke 1302 schwarz sein. Dies betrifft insbesondere die Seite 1316 der Wärmesenke 1302, welche zur Rückseite 906 des Spiegelkörpers 500 weist.

Alternativ oder zusätzlich kann die Innenseite 1318 des Gehäuses 800 derart beschichtet sein, dass das Gehäuse 800 aufgrund der Wärmesenke 1302 nicht unnötig abgekühlt wird.

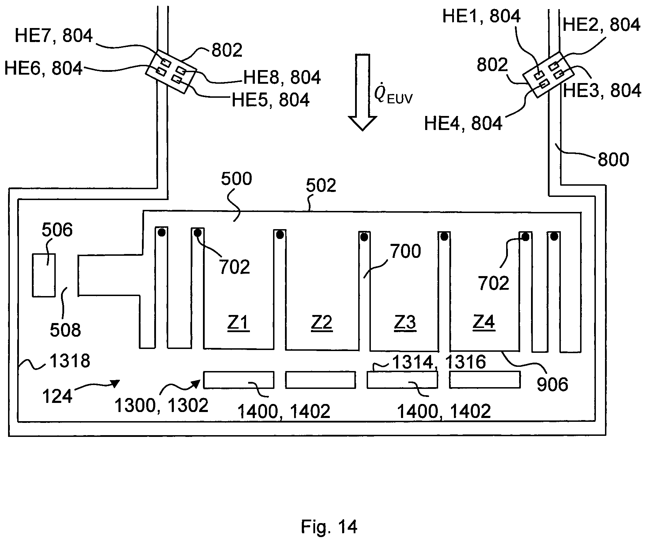

Fig. 14 zeigt den Spiegel 124 in dem Gehäuse 800 aus Fig. 13 mit einer in mehrere Segmente 1400 aufgeteilten Wärmesenke 1302. Dabei können die einzelnen Segmente 1400 als plattenförmige Elemente 1402 ausgebildet sein. Der Spiegelkörper 500 kann mehrere Zonen Z1 - Z4 aufweisen. Die Zonen Z1 - Z4 können unterschiedlich erwärmt sein. Dabei können die einzelnen Segmente 1400 derart angeordnet sein, dass sie eine Zone Z1 - Z4 separat kühlen. Beispielsweise ist, wie in Fig. 14 dargestellt, jeweils ein Segment 1400 unterhalb jeder Zone Z1 - Z4 angeordnet.

Alle Segmente 1400 können getrennt voneinander oder gemeinsam gekühlt werden. Weiter können die einzelnen Segmente 1400 mechanisch miteinander in Kontakt sein oder mechanisch getrennt voneinander angeordnet sein. Es können auch nur einige Segmente 1400 miteinander in Kontakt sein. In diesem Fall sind andere Segmente 1400 nicht mechanisch in Kontakt miteinander.

Wie in Fig. 14 dargestellt, sind die Segmente 1400 unterhalb der Rückseite 906 des Spiegelkörpers 500 angeordnet. Prinzipiell können die Segmente 1400 aber auch um den gesamten Spiegelkörper 500 herum angeordnet werden.

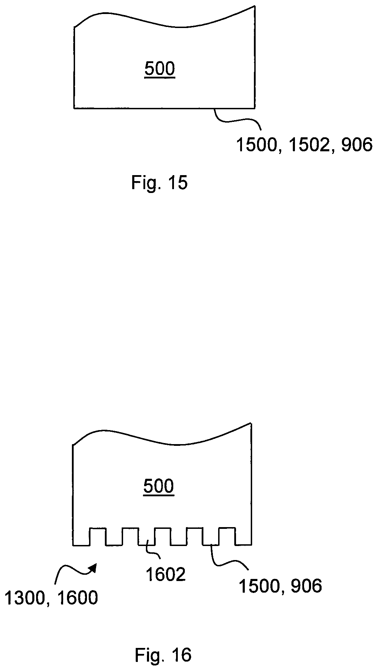

Fig. 15 zeigt eine vergrößerte Darstellung des Bereichs XV des Spiegels 124 aus Fig. 13. Zu sehen ist eine Oberfläche 1500, welche als glatte Oberfläche 1502 ausgebildet ist. Dabei kann die Oberfläche 1500 beispielsweise auf der Rückseite 906 des Spiegels 124 derart beschichtet sein, dass sie besonders gut Wärme abstrahlt. Die Beschichtung kann Nickel aufweisen. Weiter kann die Beschichtung schwarz sein.

Fig. 16 zeigt eine vergrößerte Darstellung des Bereichs XV des Spiegels 124 aus Fig. 13 mit einer alternativen Oberfläche 1500. Die Einrichtung 1300 zur Reduzierung der Spiegeltemperatur kann einen Bereich 1600 des Spiegels 124 aufweisen, bei welchem die Oberfläche 1500 aufgrund der Form der Oberfläche 1500 im Vergleich zu einer glatten Oberfläche 1502 vergrößert ist. Wie in Fig. 16 zu sehen, weist die Oberfläche 1500 Rippen 1602 auf. Aufgrund der Rippen 1602 ist die Oberfläche 1500 im Vergleich zu der glatten Oberfläche 1502 aus Fig. 15 vergrößert. Prinzipiell kann die Oberfläche 1500 eine beliebige Form aufweisen, welche die Oberfläche 1500 im Vergleich zu der glatten Oberfläche 1502 vergrößert. Aufgrund der größeren Oberfläche 1500 kann Wärme besser vom Spiegelkörper 500 in Richtung der Platte 1304 abgegeben und/oder abgestrahlt werden. Alternativ oder zusätzlich kann auch die Oberfläche 1314 der Platte 1304 vergrößert werden, um die Wärmeaufnahme der Platte 1304 zu vergrößern.

In einer weiteren Alternative kann die Oberfläche 1314 der Platte 1304 und/oder die Oberfläche 1500 des Spiegels 124 mittels einer Vergrößerung der Oberflächenrauhigkeit weiter vergrößert werden.

Es wurden die Herstellung und die Anwendung des Spiegels 124 der Lithographieanlage 100 erläutert. Die dargestellten Ausgestaltungen können jedoch selbstverständlich auch auf jeden anderen Spiegel der Lithographieanlage 100 angewendet werden.

Des Weiteren wurde auf den Spiegel 124 einer EUV-Lithographieanlage, mit einer Wellenlänge des Arbeitslichts zwischen 0,1 und 30 nm, eingegangen. Die Erfindung ist jedoch nicht auf EUV-Lithographieanlagen beschränkt, sondern kann auch auf andere Lithographieanlagen, beispielsweise DUV ("deep ultraviolet")-Lithographieanlagen, mit einer Wellenlänge des Arbeitslichts zwischen 30 und 250 nm, angewandt werden.

Obwohl die Erfindung anhand verschiedener Ausführungsbeispiele beschrieben wurde, ist sie darauf keineswegs beschränkt, sondern im Rahmen der beigefügten Patentansprüche vielfältig modifizierbar.

### BEZUGSZEICHENLISTE

- 100: EUV-Lithographieanlage
- 102: Strahlformungssystem
- 104: Beleuchtungssystem
- 106: Projektionssystem
- 108: EUV-Lichtquelle
- 110: Kollimator
- 112: Monochromator
- 114: EUV-Strahlung
- 116: erster Spiegel
- 118: zweiter Spiegel
- 120: Photomaske
- 122: Wafer
- 124: dritter Spiegel
- 126: vierter Spiegel
- 500: Spiegelkörper
- 502: optisch aktiver Bereich
- 504: optisch inaktiver Bereich
- 506: Halteeinrichtung
- 508: Bohrung der Halteeinrichtung
- 510: Wärmestrompol
- 512: X-Dipol
- 514: Y-Dipol
- 516: D-RAM-Profil
- 518: Wärmestromverteilung
- 700: Bohrung im Spiegelkörper
- 702: Temperatursensor
- 800: Gehäuse
- 802: Heizvorrichtung
- 804: Wärmestrahler
- 900: Stirnseite
- 902: Ringförmiger Randbereich
- 904: Mantelfläche
- 906: der Stirnseite gegenüberliegende Stirnseite (Rückseite)
- 1300: Einrichtung zur Reduzierung der Spiegeltemperatur
- 1302: Wärmesenke
- 1304: Platte
- 1306: Peltier-Element
- 1308: Zufuhrleitung
- 1310: Abfuhrleitung
- 1312: Durchführung
- 1314: Oberfläche der Wärmesenke
- 1316: Seite der Wärmesenke
- 1318: Innenseite des Gehäuses
- 1400: Segment
- 1402: plattenförmiges Element
- 1500: Oberfläche des Spiegels
- 1502: glatte Oberfläche des Spiegels
- 1600: Bereich des Spiegels
- 1602: Rippe

- *Q̇*: Wärmestrom
- HZ1: Heizzone 1
- HZ2: Heizzone 2
- HZ3: Heizzone 3
- HZ4: Heizzone 4
- HZ5: Heizzone 5
- HZ6: Heizzone 6
- HZ6a: erste Heizzone der aufgeteilten Heizzone 6
- HZ6b: zweite Heizzone der aufgeteilten Heizzone 6
- HZ7: Heizzone 7
- HZ7a: erste Heizzone der aufgeteilten Heizzone 7
- HZ7b: zweite Heizzone der aufgeteilten Heizzone 7
- HZ8: Heizzone 8
- HZ9: Heizzone 9
- HZ10: Heizzone 10
- HZ11: Heizzone 11
- HZ12: Heizzone 12
- HZ13: Heizzone 13
- HZ13a - HZ13i: verschiedene Heizzonen innerhalb der Heizzone 13
- HE1: Heizeinrichtung 1
- HE2: Heizeinrichtung 2
- HE3: Heizeinrichtung 3
- HE4: Heizeinrichtung 4
- HE5: Heizeinrichtung 5
- HE6: Heizeinrichtung 6
- HE7: Heizeinrichtung 7
- HE8: Heizeinrichtung 8
- HE9: Heizeinrichtung 9
- HE10: Heizeinrichtung 10
- HE11: Heizeinrichtung 11
- HE12: Heizeinrichtung 12
- HE13: Heizeinrichtung 13
- Z1: Zone 1
- Z2: Zone 2
- Z3: Zone 3
- Z4: Zone 4

## Patentansprüche

1. Verfahren zum Herstellen eines Spiegels (124) für eine Lithographieanlage (100), mit den Schritten:
Ermitteln einer zu erwartenden Wärmestromverteilung (518) auf dem Spiegel (124) in einem Belichtungsbetrieb der Lithographieanlage (100) in Abhängigkeit einer auf dem Wafer (122) abzubildenden Struktur, wobei die zu erwartende Wärmestromverteilung (518) mehrere Wärmestrompole (510) umfasst,
Bilden von mehreren Heizzonen (HZ1 - HZ13) auf dem Spiegel (124) in Abhängigkeit von der ermittelten Wärmestromverteilung (518),
Zuordnen jeweils genau eines Wärmestrompols (510) der mehreren Wärmestrompole (510) zu jeweils einer der mehreren Heizzonen (HZ1 - HZ13),
Anbringen von genau einem Temperatursensor (702) einer jeweiligen Heizzone (HZ1 - HZ13) zugeordnet zum Erfassen einer Temperatur der jeweiligen Heizzone (HZ1 - HZ13), und
Versehen der jeweiligen Heizzone (HZ1 - HZ13) mit einer jeweiligen Heizeinrichtung (HE1 - HE13) zum Beheizen der jeweiligen Heizzone (HZ1 - HZ13) in Abhängigkeit von einer mittels des jeweiligen Temperatursensors (702) erfassten Temperatur der jeweiligen Heizzone (HZ1 - HZ13) oder der zu erwartenden Wärmestromverteilung (518) auf dem Spiegel (124).

2. Verfahren nach Anspruch 1, wobei der Spiegel (124) einen optisch aktiven Bereich (502) und einen optisch inaktiven Bereich (504) aufweist und wobei im optisch aktiven Bereich (502) und/oder im optisch inaktiven Bereich (504) ein oder mehrere Heizzonen (HZ1 - HZ13) gebildet werden.

3. Verfahren nach Anspruch 1 oder 2, wobei zumindest eine Heizeinrichtung (HE 1 - HE 13) einen Wärmestrahler (804) und/oder einen Heizwiderstand aufweist.

4. Verfahren nach einem der Ansprüche 1 bis 3, wobei der Spiegel (124) mit einer Einrichtung (1300) zur Reduzierung der Spiegeltemperatur zum Kühlen eines Spiegelkörpers (500) des Spiegels (124) versehen wird.

5. Verfahren nach Anspruch 4, wobei die Einrichtung (1300) zur Reduzierung der Spiegeltemperatur eine von dem Spiegelkörper (500) beabstandet angeordnete Wärmesenke (1302) aufweist.

6. Verfahren nach Anspruch 5, wobei der Spiegelkörper (500) mehrere Zonen (Z1 - Z4) aufweist und die Wärmesenke (1302) in mehrere Segmente (1400) aufgeteilt ist, um die einzelnen Zonen (Z1 - Z4) separat zu kühlen.

7. Verfahren nach einem der Ansprüche 4 bis 6, wobei die Einrichtung (1300) zur Reduzierung der Spiegeltemperatur einen Bereich (1600) des Spiegels (124) aufweist, bei welchem eine Oberfläche (1500) aufgrund der Form der Oberfläche (1500) im Vergleich zu einer glatten Oberfläche (1502) vergrößert ist.

## Claims

1. Method for producing a mirror (124) for a lithography apparatus (100), with the steps of:
ascertaining an expected heat flux distribution (518) on the mirror (124) in an exposure operation of the lithography apparatus (100) in dependence on a structure to be imaged on the wafer (122), wherein the expected heat flux distribution (518) comprises a plurality of heat flux poles (510),
forming a plurality of heating zones (HZ1 - HZ13) on the mirror (124) in dependence on the ascertained heat flux distribution (518),
assigning in each case exactly one heat flux pole (510) of the plurality of heat flux poles (510) to in each case one of the plurality of heating zones (HZ1 - HZ13),
attaching exactly one temperature sensor (702) to a respective heating zone (HZ1 - HZ13) allocated for capturing a temperature of the respective heating zone (HZ1 - HZ13), and
providing the respective heating zone (HZ1 - HZ13) with a respective heating device (HE1 - HE13) for heating the respective heating zone (HZ1 - HZ13) in dependence on a temperature of the respective heating zone (HZ1 - HZ13) captured by means of the respective temperature sensor (702) or the expected heat flux distribution (518) on the mirror (124).

2. Method according to Claim 1, wherein the mirror (124) has an optically active region (502) and an optically inactive region (504) and wherein one or more heating zones (HZ1 - HZ13) are formed in the optically active region (502) and/or in the optically inactive region (504).

3. Method according to Claim 1 or 2, wherein at least one heating device (HE1 - HE13) has a thermal emitter (804) and/or a heat resistor.

4. Method according to one of Claims 1 to 3, wherein the mirror (124) is provided with a device (1300) for reducing the mirror temperature for cooling a mirror body (500) of the mirror (124).

5. Method according to Claim 4, wherein the device (1300) for reducing the mirror temperature has a heat sink (1302) that is arranged at a distance from the mirror body (500).

6. Method according to Claim 5, wherein the mirror body (500) has a plurality of zones (Z1 - Z4) and the heat sink (1302) is divided into a plurality of segments (1400) in order to cool the individual zones (Z1 - Z4) separately.

7. Method according to one of Claims 4 to 6, wherein the device (1300) for reducing the mirror temperature has a region (1600) of the mirror (124) in which a surface (1500) is enlarged, due to the shape of the surface (1500), as compared to a smooth surface (1502).

## Revendications

1. Procédé de fabrication d'un miroir (124) pour une installation de lithographie (100), comprenant les étapes suivantes :
déterminer une distribution de flux de chaleur (518) à laquelle on peut s'attendre sur le miroir (124) dans un mode d'exposition de l'installation de lithographie (100) en fonction d'une structure à reproduire sur la plaquette (122), la distribution de flux de chaleur (518) à laquelle on peut s'attendre comprenant plusieurs pôles de flux de chaleur (510),
former plusieurs zones de chauffage (HZ1 - HZ13) sur le miroir (124) en fonction de la distribution de flux de chaleur (518) déterminée,
associer exactement un pôle de flux de chaleur (510) de la pluralité de pôles de flux de chaleur (510) à l'une respective des multiples zones de chauffage (HZ1 - HZ13),
installer exactement un capteur de température (702) associé à une zone de chauffage respective (HZ1 - HZ13) pour acquérir une température de la zone de chauffage respective (HZ1 - HZ13), et
équiper la zone de chauffage (HZ1 - HZ13) respective d'un dispositif de chauffage (HE1 - HE13) respectif pour le chauffage de la zone de chauffage (HZ1 - HZ13) respective en fonction d'une température de la zone de chauffage (HZ1 - HZ13) respective acquise au moyen du capteur de température (702) respectif ou de la distribution de flux de chaleur (518) à laquelle on peut s'attendre sur le miroir (124).

2. Procédé selon la revendication 1, dans lequel le miroir (124) présente une zone optiquement active (502) et une zone optiquement inactive (504) et dans lequel une ou plusieurs zones de chauffage (HZ1 - HZ13) sont formées dans la zone optiquement active (502) et/ou dans la zone optiquement inactive (504).

3. Procédé selon la revendication 1 ou 2, dans lequel au moins un dispositif de chauffage (HE1 - HE13) comporte un émetteur de chaleur (804) et/ou une résistance chauffante.

4. Procédé selon l'une quelconque des revendications 1 à 3, dans lequel le miroir (124) est pourvu d'un dispositif (1300) de réduction de la température du miroir pour le refroidissement d'un corps de miroir (500) du miroir (124).

5. Procédé selon la revendication 4, dans lequel le dispositif (1300) de réduction de la température du miroir comporte un puits de chaleur (1302) agencé à distance du corps de miroir (500).

6. Procédé selon la revendication 5, dans lequel le corps de miroir (500) présente plusieurs zones (Z1 - Z4) et le puits de chaleur (1302) est divisé en plusieurs segments (1400) afin de refroidir séparément les différentes zones (Z1 - Z4).

7. Procédé selon l'une quelconque des revendications 4 à 6, dans lequel le dispositif (1300) de réduction de la température du miroir présente une zone (1600) du miroir (124) dans laquelle une surface (1500) est agrandie en raison de la forme de la surface (1500) par comparaison avec une surface lisse (1502).
